Europäisches Patentamt

European Patent Office

Office européen des brevets

(11) Publication number: **0 184 463 B1**

## EUROPEAN PATENT SPECIFICATION

(45) Date of publication of patent specification: **03.06.92**

(51) Int. Cl.5: **H01L 33/00**, H01S 3/19

(21) Application number: **85308893.8**

(22) Date of filing: **06.12.85**

(54) An optical semiconductor device.

(30) Priority: **07.12.84 JP 259569/84**

(43) Date of publication of application:
**11.06.86 Bulletin 86/24**

(45) Publication of the grant of the patent:
**03.06.92 Bulletin 92/23**

(84) Designated Contracting States:
**DE GB NL**

(56) References cited:
**EP-A- 0 124 924**
**GB-A- 2 137 812**

**APPLIED PHYSICS LETTERS, vol. 39, no. 1,
1st July 1981, pages 102-104, New York, US;
N. HOLONYAK et al.: "IR-red GaAs-AlAs
superlattice laser monolithically integrated
in a yellow-gap cavity"**

**APPLIED PHYSICS LETTERS, vol. 38, no. 2,
15th January 1981, pages 63-65, New York,
US; J. COLEMAN et al.: "High-barrier cluster-
free AlxGa1-xAs-GaAs quantum-well
heterostructure laser"**

(73) Proprietor: **SHARP KABUSHIKI KAISHA
22-22 Nagaike-cho Abeno-ku
Osaka 545(JP)**

(72) Inventor: **Hayakawa, Toshiro
17-402, Katsuragi-cho
Nara-shi Nara-ken(JP)**
Inventor: **Suyama, Takahiro
2613-1, Ichinomoto-cho
Tenri-shi Nara-ken(JP)**
Inventor: **Takahashi, Kohsei
2613-1, Ichinomoto-cho
Tenri-shi Nara-ken(JP)**
Inventor: **Yamamoto, Saburo
1-2-11, Akanedai Haibara-cho
Uda-gun Nara-ken(JP)**

(74) Representative: **Kosmin, Gerald Emmanuel et
al
HASELTINE, LAKE & CO. Hazlitt House 28
Southampton Buildings Chancery Lane
London, WC2A 1AT(GB)**

## Description

This invention relates to a high efficiency optical semiconductor device which comprises a light emitting region of a semiconductor superlattice grown by molecular beam epitaxy (MBE), metal organic-chemical vapor deposition (MO-CVD) or the like and which has a light emission wavelength in the visible region of 750 nm or less.

In recent years, with the development of information processing apparatus such as optical discs and laser beam printers for which semiconductor laser devices are used as signal light sources, shortening of the oscillation wavelength from visible semiconductor laser devices is required. In answer to this, great progress with semiconductor laser devices of the $Ga_{1-x}Al_xAs$ system has been achieved. In particular, laser devices of the 780 nm band have a long life span (more than $10^6$ hours) at room temperature, and are widely usable as a light source for compact discs. However, if the AlAs mole fraction x in a $Ga_{1-x}Al_xAs$ mixed crystal is increased so as to shorten the oscillation wavelength, the light emission mechanism in these semiconductor laser devices approaches indirect transition. In a conventional semiconductor laser device with a double heterostructure which uses as the $Ga_{1-x}Al_xAs$ mixed crystal for the active layer, as reported in the Journal of Applied Physics, vol. 54, p. 2209 (1983) by T. Hayakawa et al., when x is 0.2 or more, the oscillation wavelength is less than 750 nm, giving rise to the problem that the internal quantum efficiency is reduced causing an increase in the threshold current.

On the other hand, a multi-quantum well (MQW) structure has been proposed in which the GaAs quantum well having a thickness of approximately 5 nm (50 Å) is separated by a barrier layer of $Ga_{1-x}Al_xAs$ ($x \leq 0.5$). In the MQW structure laser device, ideally, the GaAs quantum well with a smaller energy band gap is separated by a barrier layer which has a larger energy gap than that of the quantum well, and quantization levels at each quantum well are established. However, in practice, a small amount of carrier is injected into one side of the MQW, and thus in order to increase the injection efficiency of the carriers into the quantum wells separated from the p-n junctions of the active layer, the thickness of the barrier layer must be decreased, or the energy gap must be small. Therefore, the conventional quantum well structure cannot be said to be ideal. For these reasons, the conventional MQW structure laser device has the disadvantage of having a decreased internal quantum efficiency.

In Applied Physics Letters, Vol. 39, No.1, July 1981, pp. 102-104, Holonyak et al disclose a GaAs-AlAs superlattice laser comprising 41 GaAs layers each having a thickness of about 4.5 nm (45 Å) coupled with 40 layers of AlAs each having a thickness of about 15 nm (150 Å), with an average AlAs mole fraction of about 0.77.

In EP-A-0124924 there is disclosed a semiconductor device having a superlattice structure composed of two to seven, e.g. six, monolayers of active material such as GaAs, and two to seven, e.g. four, monolayers of barrier material such as AlAs, with the number of monolayers not exceeding 12.

The optical semiconductor device of this invention which overcomes the above-discussed and numerous other disadvantages and deficiencies of the prior art, comprises a light emitting region of a superlatticed structure which is composed of binary compounds of GaAs and AlAs, the average AlAs mole fraction in said GaAs/AlAs superlatticed structure being 0.2 or more.

The superlatticed structure is composed of alternate layers consisting respectively of two kinds of semiconductor layer units, one of which consists of a single monomolecular layer of AlAs and the other of which consists of forty or fewer GaAs monomolecular layers, preferably three monomolecular layers.

Thus, the invention described herein makes possible the object of providing an optical semiconductor device in which a decrease in the light emission efficiency with an increase in the AlAs mole fraction (i.e., x) in a $Ga_{1-x}Al_xAs$ mixed crystal is inhibited so that the carrier injection efficiency can be maintained at a high level even at an oscillation wavelength of as short as 750 nm or less, thereby allowing for the reduction of the threshold current level thereof.

According to this invention, a superlatticed structure composed of binary compounds of GaAs and AlAs is used as the light emitting region of an optical semiconductor device, instead of a $Ga_{1-x}Al_xAs$ mixed crystal which has been used for the light emitting region of a conventional semiconductor laser device and/or a conventional light emitting diode, so that even when the averaged AlAs mole fraction in the GaAs/AlAs superlatticed structure is 0.2 or more, direct transition in the light emission mechanism of the optical semiconductor device of this invention can be maintained and a decrease in the light emission efficiency can be prevented.

This superlatticed structure is composed of alternate layers consisting of two kinds of semiconductor layer units, one of which consists of one monomolecular layer of AlAs and the other of which consists of forty or fewer GaAs monomolecular layers.

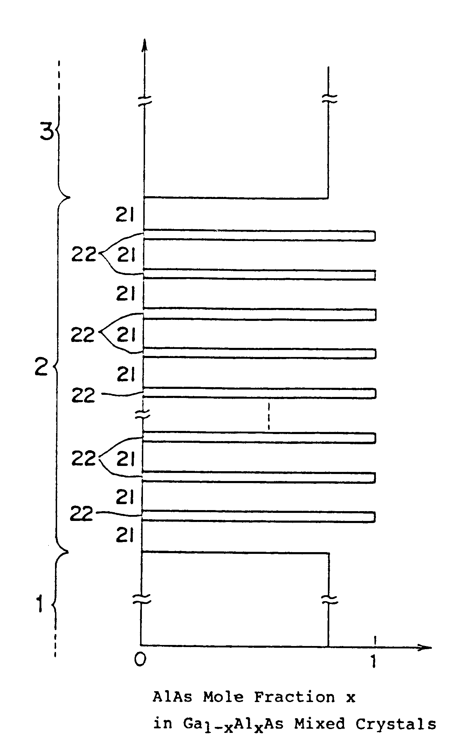

For a better understanding of the invention and to show how the same may be carried into effect, reference will now be made, by way of example, to the accompanying drawing which is a diagram showing the distribution of the AlAs mole fraction (i.e., x) in a $Ga_{1-x}Al_xAs$ semiconductor device of this invention.

The drawing shows the distribution of the AlAs mole fraction x in a $Ga_{1-x}Al_xAs$ mixed crystal in a superlatticed semiconductor laser device of this invention, which is equivalent to a double heterostructure, wherein the abscissa is the AlAs mole fraction of 1 and the GaAs mole fraction of 0, and the ordinate is the depth of growth layers.

This semiconductor laser device is produced as follows: On an n-GaAs substrate (not shown), an n-$Ga_{0.2}Al_{0.8}As$ cladding layer 1, a non-doped superlatticed active layer 2, a p-$Ga_{0.2}Al_{0.8}As$ cladding layer 3 and p-GaAs cap layer (not shown) are successively grown by molecular beam epitaxy. The superlatticed active layer 2 having a thickness of approximately 63 nm (630 Å) and the average AlAs mole fraction therein of 0.25 is composed of alternate layers consisting of fifty-six GaAs semiconductor layer units (each of which consists of three GaAs monomolecular layers) 21 and fifty-five AlAs semiconductor layer units (each of which consists of one AlAs monomolecular layer) 22. Using the resulting wafer, a broad area laser device with a length of 250 $\mu$m and a width of 100 $\mu$m was produced, which had an oscillation wavelength of 720 nm and exhibited a threshold current density of 900 A/cm$^2$ in pulse operation.

On the other hand, two reference semiconductor laser devices were produced, one of which had the same cladding layer structure as the above-mentioned device of this invention but had a non-doped $Ga_{0.75}Al_{0.25}As$ active layer with a thickness of 63 nm (630 Å), and the other of which had $Ga_{0.65}Al_{0.35}As$ cladding layers and a non-doped GaAs active layer with a thickness of 63 nm (630 Å). The former reference device had an oscillation wavelength of as short as 718 nm, but exhibited a threshold current density of as great as 1250 A/cm$^2$ in pulse operation, whereas the latter reference device had an oscillation wavelength of as long as 890 nm and exhibited a threshold current density of as small as 900 A/cm$^2$.

It can be seen from the above-mentioned experiments that, in the device of this invention, a decrease in the internal quantum efficiency is inhibited even at a short oscillation wavelength of 720 nm and the threshold current level thereof is low.

These phenomena can be explained as follows: An active layer was formed into an ideal superlattice according to this invention, resulting in zone-foldings in the reciprocal lattice space thereof which has never been attained in a conventional MQW laser device. Due to the zone-foldings, the influence of indirect transition in the conductive bands is eliminated so that an increase in the threshold current with the shortening of the oscillation wavelength can be prevented. Moreover, since the individual AlAs monomolecular layers do not act independently as a barrier layer against carriers, a decrease in the carrier injection efficiency does not arise, although it does arise in a superlattice having an ordinary thickness, thereby allowing for the maintenance of the threshold current at a low level.

## Claims

1. An optical semiconductor device comprising a light emitting region having a light emission wavelength in the visible wavelength of 750 nm or less, said emitting region being in the form of a superlatticed structure composed of a plurality of alternative layers of GaAs and AlAs respectively, each AlAs layer consisting of one AlAs monomolecular layer and each GaAs layer consisting of not more than forty GaAs monomolecular layers, the average AlAs mole fraction in the GaAs/AlAs superlatticed structure being 0.2 or more.

2. An optical semiconductor device as claimed in Claim 1, wherein each GaAs layer consists of three GaAs monomolecular layers.

## Revendications

1. Un dispositif optique semi-conducteur comprenant une zone d'émission lumineuse dont la longueur d'onde d'émission lumineuse est située dans la longueur d'onde visible de 750 nm ou moins, ladite zone d'émission étant d'une forme en surstructure composée de plusieurs couches de GaAs et de AlAs respectivement en alternance, chaque couche de AlAs étant constituée d'une couche monomoléculaire d'AlAs et chaque couche de GaAs étant au plus constituée de quarante couches monomoléculaires de GaAs, la fraction molaire moyenne d'AlAs dans la surstructure GaAs/AlAs étant de 0,2 ou davantage.

2. Un dispositif optique semi-conducteur selon la revendication 1, dans lequel chaque couche de GaAs est constituée de trois couches monomoléculaires de GaAs.

## Patentansprüche

1. Optische Halbleiteranordnung mit einem lichtaussendenden Bereich, der eine Emissionswellenlänge mit der sichtbaren Wellenlänge von 750 nm oder weniger hat, wobei der aussendende Bereich die Form einer Supergitterstruktur hat, welche aus einer Mehrzahl von abwechselnden Schichten aus GaAs und AlAs besteht, wobei jede AlAs Schicht aus einer AlAs Monomolekularschicht und jede GaAs Schicht aus nicht mehr als 40 GaAs Monomolekularschichten besteht, wobei der durchschnittliche AlAs Molanteil in der GaAs/AlAs Supergitterstruktur 0.2 oder mehr beträgt.

2. Optische Halbleiterlaseranordnung nach Anspruch 1, wobei jede GaAs Schicht aus drei GaAs Monomolekularschichten besteht.

AlAs Mole Fraction x
in $Ga_{1-x}Al_xAs$ Mixed Crystals